# EUROPEAN PATENT SPECIFICATION

(11) **EP 4 379 364 B1**
(45) Date of publication and mention of the grant of the patent: **18.11.2026**
(21) Application number: 22306771.1
(22) Date of filing: 01.12.2022
(51) Int. Cl.: G01N 24/10, G01R 33/24, G01R 33/32

(54) **METHOD AND DEVICE FOR MEASURING A MAGNETIC FIELD**
VERFAHREN UND VORRICHTUNG ZUR MESSUNG EINES MAGNETFELDES
PROCÉDÉ ET DISPOSITIF DE MESURE D'UN CHAMP MAGNÉTIQUE

(43) Date of publication of application: 05.06.2024
(73) Proprietor: Kwan-Tek, 56270 Ploemeur (FR)
(72) Inventor: BEATO, François, 56100 LORIENT (FR); GEIGER, Remi, 56530 QUEVEN (FR); HINGANT, Thomas, 35000 Rennes (FR)
(74) Representative: Yes My Patent

(56) References cited:
- FESCENKO ILJA ET AL: "Diamond magnetometer enhanced by ferrite flux concentrators", PHYSICAL REVIEW RESEARCH, vol. 2, no. 2, 1 June 2020 (2020-06-01), XP055936990, DOI: 10.1103/PhysRevResearch.2.023394
- HANNAH CLEVENSON ET AL: "Broadband magnetometry and temperature sensing with a light-trapping diamond waveguide", NATURE PHYSICS, vol. 11, no. 5, 6 April 2015 (2015-04-06), GB, pages 393 - 397, XP055320988, ISSN: 1745-2473, DOI: 10.1038/nphys3291
- DMITRIEV A L ET AL: "Concept of a microscale vector magnetic field sensor based on nitrogen-vacancy centers in diamond", JOURNAL OF THE OPTICAL SOCIETY OF AMERICA B,, vol. 33, no. 3, 1 March 2016 (2016-03-01), XP002773654
- RONDIN L ET AL: "Magnetometry with nitrogen-vacancy defects in diamond", REPORTS ON PROGRESS IN PHYSICS, INSTITUTE OF PHYSICS PUBLISHING, BRISTOL, GB, vol. 77, no. 5, 6 May 2014 (2014-05-06), pages 56503, XP020261950, ISSN: 0034-4885, [retrieved on 20140506], DOI: 10.1088/0034-4885/77/5/056503
- CLEVENSON HANNAH ET AL: "Robust high-dynamic-range vector magnetometry with nitrogen-vacancy centers in diamond", APPLIED PHYSICS LETTERS, AMERICAN INSTITUTE OF PHYSICS, 2 HUNTINGTON QUADRANGLE, MELVILLE, NY 11747, vol. 112, no. 25, 22 June 2018 (2018-06-22), XP012229466, ISSN: 0003-6951, [retrieved on 20180622], DOI: 10.1063/1.5034216
- ZHAO BINBIN ET AL: "High-Sensitivity Three-Axis Vector Magnetometry Using Electron Spin Ensembles in Single-Crystal Diamond", IEEE MAGNETICS LETTERS, vol. 10, 9 January 2019 (2019-01-09), pages 1 - 4, XP011708340, ISSN: 1949-307X, [retrieved on 20190206], DOI: 10.1109/LMAG.2019.2891616
- JEONG HYUN SHIM ET AL: "Multiplexed sensing of magnetic field and temperature in real time using a nitrogen vacancy spin ensemble in diamond", ARXIV.ORG, CORNELL UNIVERSITY LIBRARY, 201 OLIN LIBRARY CORNELL UNIVERSITY ITHACA, NY 14853, 25 April 2021 (2021-04-25), XP081943969
- BENJAMIN FORTMAN ET AL: "Understanding the Linewidth of the ESR Spectrum Detected by a Single NV Center in Diamond", ARXIV.ORG, CORNELL UNIVERSITY LIBRARY, 201 OLIN LIBRARY CORNELL UNIVERSITY ITHACA, NY 14853, 18 July 2019 (2019-07-18), XP081443964, DOI: 10.1021/ACS.JPCA.9B02445

## Description

### TECHNICAL FIELD

A method and device for measuring a magnetic field are disclosed. The device and method can be used in particular in the area of optical magnetic resonance detection.

### BACKGROUND

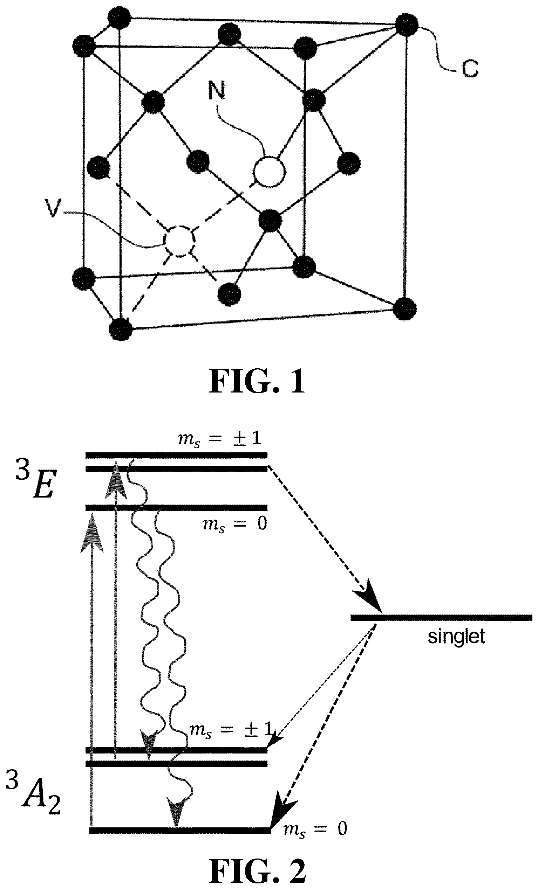

NV center doped diamonds are a promising candidate for measuring various physical parameters such as magnetic fields. An NV center is a combination of a Nitrogen atom and a Vacancy as nearest neighbors in the diamond lattice, as shown in Fig. 1, where N and C represent Nitrogen and Carbon atoms respectively, and V represents a vacancy. An NV center exists in two charge states, usually called NV0 and NV-. When used herein, 'NV' refers only to the NV- defects, which exhibit several very interesting properties for quantum sensing.

As illustrated by the diagram of Fig. 2, the fundamental state of the NV center is a spin triplet state, whose three Zeeman sublevels are called |mₛ 〉 =-1, 0 ,+1. The |mₛ 〉 = 0 is lower in energy than the |mₛ 〉 = ±1, by Dg≈2.87 GHz. It is to be noted that energy and frequency units are used equivalently herein, since they are proportional by a coefficient which is the Planck constant. Under the application of a magnetic field, along the axis of the NV center, the two |mₛ 〉=±1 energies E move as: ${E}_{\pm 1} \approx {D}_{g} \pm {γB}_{NV}$ (eq. 1) where γ is the gyromagnetic factor of the fundamental state of the NV centers and B is the magnitude of the magnetic field at the NV centers, with *γ* = 28.035(5) *GHz*/*T.*

These levels also differ from each other by the fact that when absorbing green light photons, NV centers in the |mₛ 〉 =0 state will mostly reemit light in the red range of the visible spectrum, ending in the same level as they departed from. On the other hand, NV centers in the |mₛ 〉=±1 states have an important probability of undergoing nonradiative transitions. For this reason, the |mₛ 〉=0 and |mₛ 〉=±1 states are usually respectively referred to as bright and dark states. Finally, while these transitions occur, the nonradiative decay has a 1/3 probability of ending in the |mₛ 〉=0 state. After a long time of illumination, the NV centers of the diamond can then be optically pumped into the |mₛ 〉=0 level of the fundamental state.

In addition to that, it is of importance to mention that under the application of an oscillating magnetic field (microwave field), it is possible to induce transitions between the |mₛ 〉=±1 and |mₛ 〉=0 levels, if the frequency of the field is of the order: ${f}_{RF} \approx {D}_{g} \pm {γB}_{NV}$ (eq. 2)

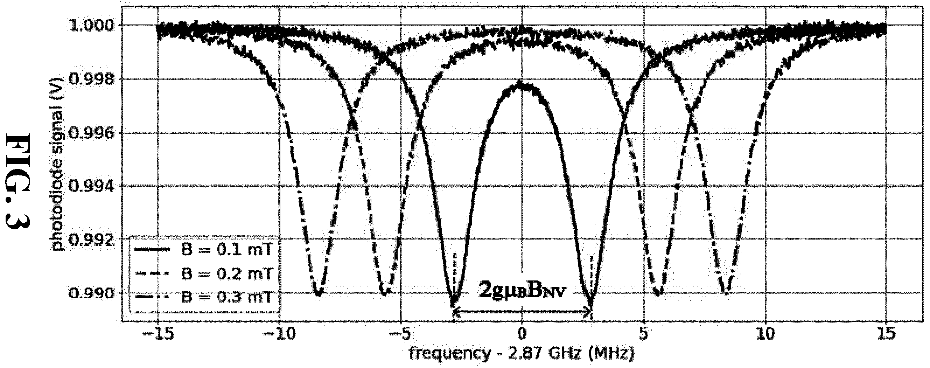

When occurring, these transitions force NV centers to undergo the nonradiative decay path, hence producing less intense fluorescence. The evolution of the red fluorescence upon both a static and microwave magnetic field is shown in Fig. 3 for several static magnetic fields. Using these properties for measurement is referred to as 'Optically Detected Magnetic Resonance' (ODMR) and is of great interest for magnetic field sensing applications, like presented in the following research papers: FESCENKO ILJA ET AL: "Diamond magnetometer enhanced by ferrite flux concentrators", PHYSICAL REVIEW RESEARCH, vol. 2, no. 2, 1 June 2020 (2020-06-01), DOI: 10.1103/PhysRevResearch.2.023394, or HANNAH CLEVENSON ET AL: "Broadband magnetometry and temperature sensing with a light-trapping diamond waveguide", NATURE PHYSICS, vol. 11, no. 5, 6 April 2015 (2015-04-06), pages 393-397, GB, ISSN: 1745-2473, DOI: 10.1038/nphys329, or also DMITRIEV A L ET AL: "Concept of a microscale vector magnetic field sensor based on nitrogen-vacancy centers in diamond", JOURNAL OF THE OPTICAL SOCIETY OF AMERICA B, vol. 33, no. 3, 1 March 2016 (2016-03-01).

It can also be noted that given the structure of a diamond, NV can exist in four specific directions, namely the (111) directions.

In certain applications of ODMR, a static magnetic field is applied for biasing purposes. The bias magnetic field is necessary to distinguish between the two transitions ms=0->ms=-1 and ms=0-> ms=+1, which cannot be spectrally resolved in the absence of a magnetic field owing to their complete mixing at low field, associated to strain inhomogeneities in the diamond crystal. With the typical strain parameter of few hundreds of kHz in quantum grade diamonds, a magnetic field of the order of few hundreds of micro Tesla is necessary. The approach of adding a static magnetic field however has several drawbacks.
- First, an additional component or module is required, such as a magnet or a coil for generating the additional magnetic field.
- Second, any variation of the additional magnetic field is difficult to distinguish from a variation coming from an item or device under test ('DUT'), except if the frequencies of variations involved are very different.
- The magnitude of the additional magnetic field may for example vary due to temperature drift, which can be difficult to avoid in many common situations. A condition on the system frequencies can be added - this is however not necessarily possible or to the least makes the sensor device more complex.
- Finally, when performing vectorial measurements using the resonances of at least two NV directions, the system requires careful alignment and orientation stability.

### SUMMARY

The scope of protection is set out by the claims. A first aspect concerns a method for measuring a first magnetic field, comprising:
- applying an time oscillating magnetic field to a diamond comprising nitrogen-vacancy centers, the magnetic field having an amplitude;
- exposing the nitrogen-vacancy centers to the first magnetic field;
- applying a microwave signal to the diamond; illuminating the diamond using green light for causing the nitrogen-vacancy centers to emit a fluorescence;
wherein the amplitude of the oscillating magnetic field is sufficiently high to cause resonances in the fluorescence at the microwave signal frequency or at harmonics of the microwave signal frequency;
- determining a timing of the resonances;
- obtaining a measurement of the first magnetic field as a function of the timing of the resonances, the timing of the resonances being obtained by timestamping the drops in the fluorescence signal using a counter.

According to one or more embodiments, the microwave signal is a fixed frequency signal. According to one or more embodiments, the fixed frequency is located outside of a frequency range comprising a nitrogen-vacancy zero-field splitting frequency, said range being a range in which a mechanical strain of the diamond impacts the measurement.

According to one or more embodiments, the method comprises providing the microwave signal at a plurality of fixed frequencies outside of the range and determining timing of resonances at each of said plurality of fixed frequencies to obtain the measurement of the first magnetic field.

According to one or more embodiments, the method comprises setting the oscillating magnetic field at a specific angle with respect to each orientation of the nitrogen-vacancy centers such that the projected field along each orientation is different so that the timing of the resonances for each orientation is different; and
- obtaining a separate measurement of the magnetic field to be measured for each orientation based on the respective timing of the resonances.

According to one or more embodiments, the method comprises averaging respective timings of a subset of resonances during a phase of the oscillating excitation magnetic field and obtaining said measurement of the magnetic field based on the averaged timings.

A second aspect concerns a device for measuring a first magnetic field comprising:
- a diamond doped with NV centers;
- a green light source arranged for optically pumping the NV centers;
- a photodetector for detecting a fluorescence of the NV centers;
- a microwave source generating a microwave frequency signal for application to the NV centers;
- a source of an oscillating magnetic excitation field;
- a processor for processing the signal from photodetector and providing one or more magnitude values of the first magnetic field, by measuring the first magnetic field as a function of the timing of the resonances, the timing of the resonances being obtained by timestamping the drops in the fluorescence signal using a counter;
- a memory with software code which, when run by the processor, causes the device to perform one of the methods described herein.

### BRIEF DESCRIPTION OF THE DRAWINGS

Example embodiments will be more fully understood from the detailed description provided herein and the accompanying drawings, which are given by way of illustration only. In the present description and in the drawings, the notations X_y and X_{y} are equivalent.
FIG. 1 is a schematic representation of a diamond lattice with an NV center;
FIG. 2 is a schematic representation of the energy levels of the fundamental state of an NV center;
FIG. 3 is a schematic diagram of simulated curves in optical detection of magnetic resonance ('ODMR');
FIG. 4 is a flowchart of a method according to a first exemplary non-limiting embodiment;
FIG. 5 is a schematic diagram illustrating the principles of the application of an oscillating magnetic field for the purpose of measuring a magnetic field according to one or more non-limiting exemplary embodiments;
FIG. 6 is a schematic diagram of a fluorescence signal as a function of time for several examples of magnetic fields, according to one or more non-limiting exemplary embodiments;
FIG. 7 is a flowchart of a method according to a second exemplary non-limiting embodiment;
FIG. 8 is a schematic diagram illustrating the principles of the application of an oscillating magnetic field for the purpose of measuring a magnetic field according to the second embodiment;
FIG. 9 is a functional block diagram of a device according to one or more non-limiting embodiments.

It should be noted that these figures are intended to illustrate the general characteristics of methods, structure and/or materials utilized in the described exemplary embodiments. The drawings are not to scale and should not be interpreted as limiting the range of values or properties encompassed by the exemplary embodiments.

### DETAILED DESCRIPTION

Various exemplary embodiments will now be described more fully with reference to the accompanying drawings. However, specific structural and functional details disclosed herein are merely representative for purposes of describing example embodiments. The exemplary embodiments may be embodied in many alternate forms and should not be construed as limited to only the embodiments set forth herein. It should be understood that there is no intent to limit example embodiments to the particular forms disclosed.

It should be appreciated by those skilled in the art that any functions, engines, block diagrams, flow diagrams, state transition diagrams and / or flowcharts herein represent conceptual views of illustrative circuitry embodying the principles of the exemplary embodiments. Functions, actions or steps described herein can be implemented in hardware or software or any combination thereof. If implemented in software, the functions, blocks of the block diagrams and/or flowchart illustrations can be implemented e.g. using software code executed by a processor or a processing device.

In the present description, functional blocks denoted as "means configured to perform ..." a certain function are to be understood as functional blocks comprising circuitry that is adapted for performing or configured to perform a certain function. Moreover, any entity described herein as "means", may be implemented as one or more distinct entities or within an entity providing additional functions. When provided by a processor, the functions may be provided by a single processor or several processors. Moreover, the term "processor" includes one or more of a digital signal processor, remote processor, graphical processing units ('GPUs'), dedicated or generic circuitry, read only memory for storing software, random access memory, and non-volatile storage.

### First embodiment

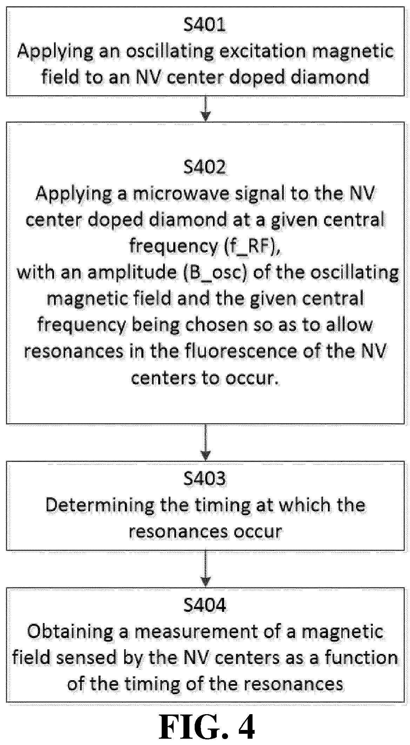

Fig. 4 is a flowchart of a method according to a first embodiment. At S401, an oscillating magnetic field is applied to an NV center doped diamond. In addition (S402), a microwave field is applied to the NV centers at a given center frequency (called 'f_{RF}' in what follows). The center frequency f_{RF} of the microwave field and the amplitude (B_{osc}) of the oscillating magnetic field are chosen so that the oscillations of the magnetic field will induce resonances (i.e. drops in the fluorescence of the NV centers) at the microwave frequency when the NV centers are excited by an appropriate green light as previously described. A temporal signal of the occurrence of the resonances is derived from the fluorescence signal collected from the NV centers. This signal is analyzed (S403) to determine the timing of the resonances. The timing is then used to determine the magnetic field (S404).

Through the application of the oscillating magnetic field, the resonances will induce regular drops in the fluorescence of the NV centers received by a photodetector of the sensor device when crossing of the NV energy levels occurs at the microwave frequency ***f_{RF}.*** These drops induce a specific temporal pattern on the temporal fluorescence signal of the photodetector. According to one or more embodiments, this pattern is used to determine the magnitude of the magnetic field to be measured. As an analogy, each magnetic field value will generate a temporal 'barcode', that can be traced back to the magnitude of the magnetic field to be measured.

If a magnetic field ***Bₘ*** to be measured is present, the phases of the oscillating magnetic field at which resonances occur (based on the instants in time at which the drops in fluorescence happen) will shift to either shorter phases or longer phases in a deterministic way, depending on the magnitude of the magnetic field to be measured. By measuring the shifts in fluorescence drops as a function of time, the magnetic field seen by the NV centers can be determined.

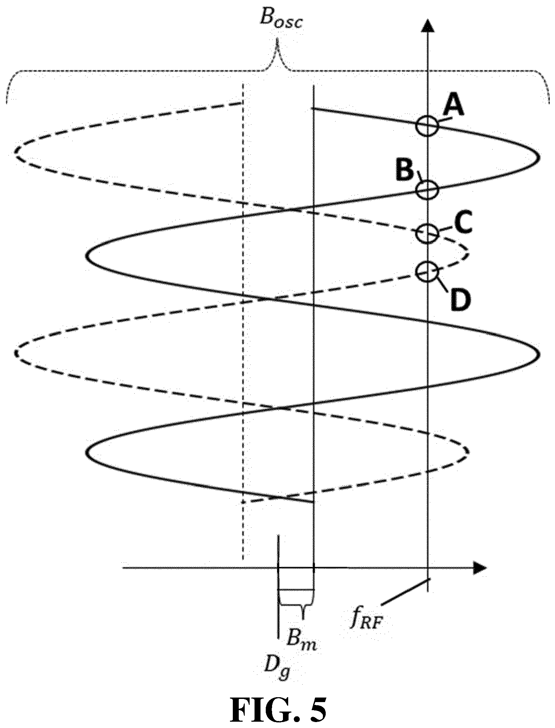

Fig. 5 is a schematic diagram illustrating the principles of a magnetic field measurement according to the first embodiment. In Fig. 5, ***D_{g}.*** is the zero field splitting frequency of an NV center (approx. 2.87 GHz) and ***Bₘ*** is the magnitude of the magnetic field to be measured. When ***B_{osc}*** is applied and ***Bₘ*** is null, the oscillating field Bosc will create an oscillation around the center frequency ***D_{g}.*** When ***Bₘ*** is not null, the oscillating magnetic field will create an oscillation around ***D_{g}** + **γBₘ*** for |mₛ 〉 =+1 and symmetrically around ***D_{g}** - **γBₘ*** for | mₛ 〉 =-1. These two oscillations are illustrated respectively with a continuous line for | mₛ 〉 =+1 and with a dashed line for | mₛ〉 =-1. The resonances appear at the crossings with the microwave signal which in the exemplary illustration of Fig. 5 is taken to be at a fixed frequency ***f_{RF}.*** In the exemplary illustration of Fig. 5, ***Bₘ*** is taken as being positive. The crossings at ***f_{RF}*** for the oscillating field associated with | mₛ〉 =+1 are labelled A and B, whereas those for the oscillating field associated with | mₛ 〉 =-1 are labelled C and D. Because of the shift in two opposite directions, the distances between A and B on one hand and C and D on the other are different, except when both oscillating fields are superposed for ***Bₘ*** = 0. Note that again for simplicity, coefficients like *γ* are not shown in Fig. 5.

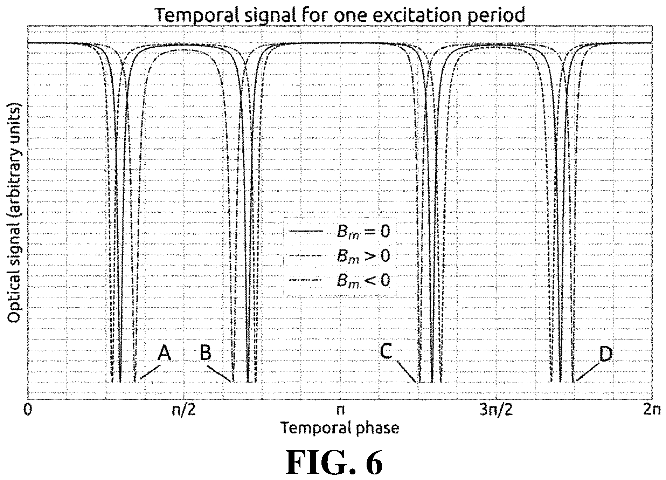

Fig. 6 is a graph of the temporal photodetector signals showing for illustrative purposes the phases of the resonances for three different exemplary magnetic fields Bm to be measured (e.g. smaller, greater or equal to 0). For ***Bₘ*** > **0,** the resonances corresponding to the intersections A, B, C and D described in relation with Fig. 5 with ***f_{RF}*** are represented over time. The shift of these points as a function of ***Bₘ*** from the position for ***Bₘ*** = **0** is proportional to ***Bₘ.***

In mathematical terms, one can describe the times at which the resonances occur using the equations detailed below.

A drop of fluorescence (i.e. a resonance) occurs when: ${f}_{RF} = {D}_{g} + κ . Δ T \pm γ . \left(\left({B}_{0}+ΔB\right).osc\left(ωt\right)+{B}_{m}\right)$ (eq. 3) where:
- κ.ΔT is the frequency evolution of the resonances due to temperature drift, with κ being a proportionality factor, κ=-74kHz/K;
- (B₀+ΔB).osc(ωt) = ***B_{osc}*osc(ωt)** is an oscillating magnetic field applied to the system with osc(ωt) being a periodic function of time, such as e.g. a sine, cosine or triangle function;
- ΔB is a potential drift in the amplitude B₀ of the oscillating magnetic field; and
- Bₘ is the magnetic field to be measured, e.g. a magnetic field induced by an item under test.

The oscillating function can be written as: $osc \left(ωt\right) = \pm \frac{{f}_{RF} - {D}_{g} - κ . Δ T ∓ {γB}_{m}}{γ \left({B}_{0}+ΔB\right)}$ (eq. 4)

In the linear range of a sine wave for instance, the four resonance phases are found to be (equations 3): ${ω}_{1} t = \frac{{f}_{RF} - {D}_{g} - κ . Δ T - {γB}_{m}}{γ \left({B}_{0}+ΔB\right)} + 2 kπ ,$ ${ω}_{2} t = π + \frac{- {f}_{RF} + {D}_{g} + κ . Δ T + {γB}_{m}}{γ \left({B}_{0}+ΔB\right)} + 2 kπ ,$ ${ω}_{3} t = \frac{- {f}_{RF} + {D}_{g} + κ . Δ T - {γB}_{m}}{γ \left({B}_{0}+ΔB\right)} + 2 kπ ,$ ${ω}_{4} t = π + \frac{+ {f}_{RF} - {D}_{g} - κ . Δ T + {γB}_{m}}{γ \left({B}_{0}+ΔB\right)} + 2 kπ$

Within one time period of the oscillating magnetic field (chosen so that the 2kπ terms will not impact the result), appropriate summing and differentiating of the expressions of the phases of the resonances to obtain 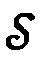 = **(-*ω*₁** + ***ω*₂** - ***ω*₃** + ***ω*₄)** leads to: ${\sum }_{i} {\left(-1\right)}^{i} {ω}_{i} t = \frac{4 {B}_{m}}{{B}_{0} + Δ B}$ (eq. 5)

This global phase difference is directly proportional to the magnetic field to be measured. It is also insensitive to temperature drifts of the NV diamond.

The person skilled in the art can derive equivalent expressions when the periodic signal is a signal other than a sine wave.

In practice, the timing of the crossings of the frequency at which the microwave signal is generated is obtained by timestamping the drops in the fluorescence signal using a counter.

According to one or more variant embodiments, the drift ΔB in the amplitude of the oscillating magnetic field is corrected. Indeed, this term may cause measurement errors. Amplitude drift can occur because of current source noise, coil distortion and other reasons.

According to one variant embodiment, the following process is optionally applied to determine the amplitude drift:
- Two microwave frequencies, ***f*_{*RF*1}** and ***f_{RF}***, are used instead of a single one. The frequencies are used alternatively to obtain phases as previously described.
- The phases at resonance are combined differently. By summing so that ( 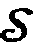 = ***ω*₁ + *ω*₄ - *ω*₂ - *ω*₃),** the following expressions are obtained for ***f*_{*RF*1}** and ***f*_{*RF*2}** respectively: 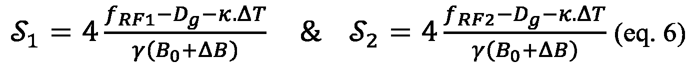
This is a system of two equations with two unknowns, ΔT and ΔB, that can easily be solved. Once ΔB (or **(*B*₀** *+* **Δ*B*))** is obtained, the value can be used in equation 5.

In the above example, all four resonances are used to obtain the magnitude of the magnetic field to be measured and make it insensitive to potential drifts . According to another variant embodiment, the method is performed using a different number of resonances. For example, a single resonance / temporal drop, or two specifically chosen drops within the time period of the excitation oscillating magnetic field can be used. One could also use several such periods to integrate over (e.g. two periods, to take into consideration eight resonances), but the system would then be slower.

According to one or more embodiments, the device comprises a lock-in amplifier after the signal detection. The excitation being performed at a specific frequency, the resulting signal will contain harmonics of this frequency. These harmonics can also be used to recover the useful information for determining the magnetic field to be measured. Using the center frequency or their harmonics is equivalent. If the time domain signal of the resonances is decomposed into Fourier series, one can see that the first harmonic varies linearly with the amplitude of the magnetic field to be measured.

According to one or more embodiments, the same principle as previously described may be applied to perform a 3D vectorial measurement of the magnetic field. To achieve this, the oscillating magnetic field is set at a specific angle with respect to each NV orientation (axis) such that the projected field along each orientation is different. This way, when the field oscillates, each NV resonance crosses the microwave frequency at a different time, creating a specific time pattern. This specific time pattern is then a specific signature of a measured magnetic field value for a given orientation.

According to one or more embodiments, several microwave frequencies are used in order to increase the signal strength. This allows increasing the sensitivity of the sensor. One possibility is to select a second microwave frequency symmetrically compared to a first microwave frequency ***f*₁** with respect to ***D_{g},*** so that **|*f*₁ *- D_{g}*| *=* |*f*₂ *- D_{g}*|.**

Unless specified otherwise, all options and variants described in relation with the first embodiment can also be applied to the second embodiment.

### Second embodiment

The second embodiment builds on the first embodiment and features and/or implementation details discussed in conjunction with the first embodiment also apply to the second embodiment.

The description of a second embodiment will provide more details of the general principles of using an oscillating magnetic field for excitation of the NV centers and a microwave field to obtain a measurement of a magnetic field, for example a magnetic field created by an DUT. The second embodiment is especially advantageous when measuring small magnetic fields and allows limiting the impact of mechanical strains in the diamond on the measurement to be made.

Mechanical strains may exist in bulk diamonds. In the presence of a mechanical strain, the energy levels usually do not depend on the magnetic field magnitude for small magnetic fields. The resonance frequencies follow the relation: ${f}_{\pm } \approx {D}_{g} \pm \sqrt{{E}^{2} + {\left({γB}_{NV}\right)}^{2}}$ (eq. 7) where E represents the mechanical strain inside the material. This phenomenon is hence detrimental to sensing low-magnitude magnetic fields.

It is possible to apply a static magnetic field to move the NV centers out of the magnetic field range where they are not sensitive because of the mechanical strain. Even a small variation of the magnetic field can then be measured by the sensor device. Small variations to be measured may typically be those induced by a DUT.

The approach of adding a static magnetic field however has several drawbacks, as described in conjunction with the first embodiment.

A device for sensing magnetic fields in conditions where the presence of mechanical strains in the diamond poses a problem is hence desirable.

According to the second embodiment, an oscillating magnetic field is applied to the NV centers, with the amplitude B_{osc} of this oscillating magnetic field chosen large enough so that NV resonance frequencies occur outside of the center zone around the zero field splitting in which the effects of the mechanical strain dominate.

In addition, a microwave field is applied to the NV centers at a fixed frequency f_{RF}. The frequency of the microwave field is chosen to ensure that resonances occur outside of the area influenced by the mechanical strain and under the influence of the oscillating magnetic field. For this purpose, the fixed frequency is chosen such that **|*f_{RF}*** - ***D_{g}*| *> E.***

In addition, ***B_{osc}*** is chosen large enough that the fixed frequency f_{RF} is crossed when the magnetic field oscillates, i.e. that resonances occur when the magnetic field surges and when it diminishes. For this purpose, the amplitude of the oscillating magnetic field is chosen such that ***B_{osc}** >* **|*f_{RF}*** - ***D_{g}***| *> **E.***

Exemplary values of E in a typical diamond are between 0.1 and 1 MHz, E being expressed in terms of frequency. ***f_{RF}*** can for example be chosen having the higher end of the range for E in mind, with an appropriate safety margin, so as to be placed at a point where the influence of E is considered negligible, and ***B_{osc}*** is then chosen based on ***f_{RF}***.

As indicated earlier, through the application of the oscillating magnetic field, the resonances will induce regular drops in the fluorescence of the NV centers received by a photodetector of the sensor device when crossing of the NV energy levels occurs at the microwave frequency ***f_{RF}.*** These drops induce a specific temporal pattern on the temporal fluorescence signal of the photodetector. This pattern is used to determine the magnitude of the magnetic field to be measured. If a magnetic field ***Bₘ*** to be measured is present, the phases of the oscillating magnetic field at which resonances occur (based on the instants in time at which the drops in fluorescence happen) will shift to either shorter phases or longer phases in a deterministic way, depending on the magnitude of the magnetic field to be measured. By measuring the shifts in fluorescence drops as a function of time, the magnetic field seen by the NV centers can be determined, even when small and under the value of E.

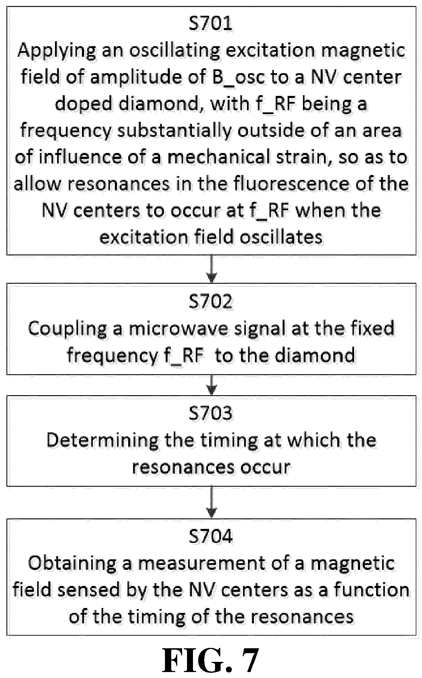

Fig. 7 is a flowchart of a method according to the second embodiment. At S701, an oscillating magnetic field is applied to an NV center doped diamond. In addition (S702), a microwave field is applied to the NV centers at a given center frequency f_{RF}. The center frequency f_{RF} of the microwave field and the amplitude (***B_{osc}***) of the oscillating magnetic field are chosen so that the oscillations of the magnetic field will induce resonances (i.e. drops in the fluorescence of the NV centers) at the microwave frequency when the NV centers are excited by an appropriate green light as previously described. They are also chosen so that f_RF is a frequency substantially outside of the area of influence of the mechanical strain. A temporal signal of the occurrence of the resonances is derived from the fluorescence signal collected from the NV centers. This signal is analyzed (S703) to determine the timing of the resonances. The timing is then used to determine the magnetic field (S704).

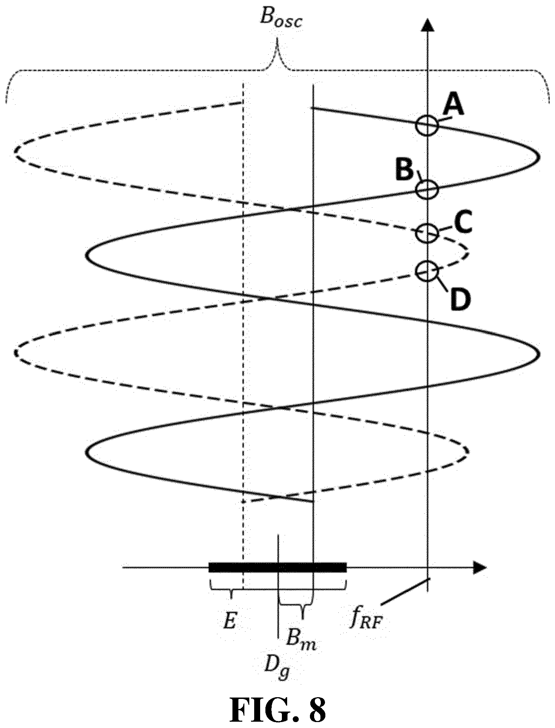

Fig. 8 is a schematic diagram similar to that of Fig. 5, but showing schematically the area around the zero field splitting impacted by the mechanical strain and outside of which the resonances are to be obtained by an appropriate choice of the fixed microwave frequency and the amplitude of the magnetic field. The bracket labelled E represents the frequency area around D_{g} to be avoided with regard to the impact of the mechanical strain. Measurements of the magnetic field to be measured, ***Bₘ,*** can be performed as discussed with regard to the first embodiment.

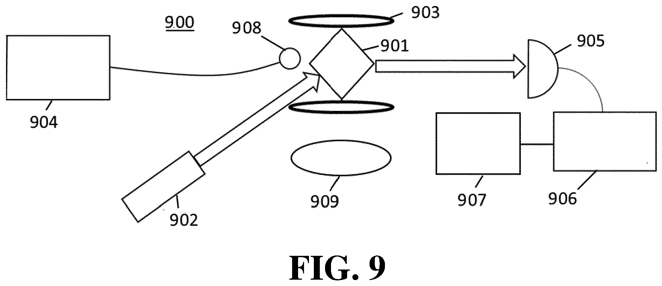

Fig. 9 is a block diagram of a device for carrying out the processes to one or more of the above embodiments. The device comprises:
- A diamond 901 doped with NV centers that will be used as sensing component.
- A green light source 902 used for optical pumping of the NV centers into the |mₛ 〉=0 state.
- A photodetector 905 such as a photodiode for detecting the red fluorescence of the NV centers for instance.
- A processor 906 for processing the signal from detector 905 and providing one or more magnitude values of the magnetic field to be measured.
- A memory 907 with software code run by the processor 906 for causing the device 900 to perform the methods described.
- A microwave source 904 generating a microwave frequency signal.
   According to one or more embodiments, the central frequency is around the zero field splitting of the NV center (2.87 GHz), e.g. between 2.03 GHz and 3.71 GHz. According to the second embodiment, the microwave source is configured to provide at least a signal at the central frequency.
- A microwave resonator 908 connected to the microwave source for coupling the microwave signal to the diamond 901.
- A source 903 of an oscillating magnetic field. According to one embodiment, this source is a coil 903 generating an oscillating magnetic field. The maximum amplitude of the field may be between a few hundred µT (e.g. 100 µT) and a few tenths or hundred mT (e.g. 1 mT). As long as sufficient power is available, the oscillating field amplitude can be increased without damaging the device's performance.

It is to be noted that depending on the implementation, not all components above are necessarily present within a single physical device. Some components or groups of components may be remote. E.g. the diamond 901, the source 903 of the oscillating magnetic field and the resonator 908 may be placed in a sensor head connected to a device through a cable comprising one or more optical fibers for conducting the green excitation light and the fluorescence, and a conductor for conducting the microwave signal to the resonator. Other set-ups may be considered depending on the requirements of an individual application context.

The device may comprise one or more interfaces for allowing a user to control the device and/or for outputting measurements in various formats, e.g. as raw measurements, including timestamps of the resonances, partially or fully processed data, as a display signal for display on an internal or external display...

An item under test 909 is also shown in Fig. 9. The item under test generates a magnetic field ***Bₘ*** and is placed in such a way that the sensing diamond 901 is at least partially placed within the magnetic field ***Bₘ.*** Item 909 is not part of the device 900.

The microwave source 904 may also be configured to provide a microwave signal at several frequencies, e.g. when the variant embodiment for correcting the oscillating magnetic field amplitude drift is to be implemented.

According to one or more exemplary embodiments, the device is configured to apply the oscillating magnetic field along a single NV center axis inside the diamond. This allows performing a vectorial measurement of the magnetic field along this NV axis.

According to variants of the above embodiments, the device uses signals other than the red fluorescence from the NV centers to measure the magnetic field. For example, it would be physically equivalent, relative to the described embodiments, to use the infrared fluorescence around 1042 nm or an electrical signal obtained by collecting photoelectrons within the diamond.

## Claims

1. A method for measuring a first magnetic field (Bₘ), comprising:
- applying (S401) a time oscillating magnetic field to a diamond (901) comprising nitrogen-vacancy centers, the magnetic field having an amplitude (***B_{osc}***);
- exposing the nitrogen-vacancy centers to the first magnetic field;
- applying (S402) a microwave signal to the diamond; illuminating the diamond using green light for causing the nitrogen-vacancy centers to emit a fluorescence;
wherein the amplitude of the oscillating magnetic field is sufficiently high to cause resonances in the fluorescence at the microwave signal frequency or at harmonics of the microwave signal frequency;
- determining (S403) a timing of the resonances;
- obtaining (S404) a measurement of the first magnetic field as a function of the timing of the resonances, the timing of the resonances being obtained by timestamping the drops in the fluorescence signal using a counter.

2. Method according to claim 1, wherein the microwave signal is a fixed frequency (f_{RF}) signal.

3. Method according to claim 2, wherein the fixed frequency is located (S701) outside of a frequency range comprising a nitrogen-vacancy zero-field splitting frequency (D_{g}), said range being a range in which a mechanical strain (E) of the diamond impacts the measurement.

4. Method according to claim 3, comprising providing the microwave signal at a plurality of fixed frequencies outside of the range and determining timing of resonances at each of said plurality of fixed frequencies to obtain the measurement of the first magnetic field.

5. Method according to one of the claims 1 to 4, further comprising
- setting the oscillating magnetic field at a specific angle with respect to each orientation of the nitrogen-vacancy centers such that the projected field along each orientation is different so that the timing of the resonances for each orientation is different; and
- obtaining a separate measurement of the magnetic field to be measured for each orientation based on the respective timing of the resonances.

6. Method according to one of the claims 1 to 5, further comprising averaging respective timings of a subset of resonances during a phase of the oscillating excitation magnetic field and obtaining said measurement of the magnetic field based on the averaged timings.

7. Device (900) for measuring a first magnetic field (Bₘ), comprising:
- a diamond (901) doped with NV centers;
- a green light source (902) arranged for optically pumping the NV centers;
- a photodetector (905) for detecting a fluorescence of the NV centers;
- a microwave source (904) generating a microwave frequency signal for application to the NV centers;
- a source (903) of a time oscillating magnetic field;
- a processor (906) for processing the signal from photodetector and providing one or more magnitude values of the first magnetic field, by measuring the first magnetic field as a function of the timing of the resonances, the timing of the resonances being obtained by timestamping the drops in the fluorescence signal using a counter;
- a memory (907) with software code which, when run by the processor, causes the device to perform a method according to one of the claims 1 to 6.

## Patentansprüche

1. Verfahren zum Messen eines ersten Magnetfelds (Bₘ), umfassend:
- Anlegen (S401) eines zeitlich oszillierenden Magnetfelds an einen Diamanten (901), umfassend Stickstoffleerstellenzentren, wobei das Magnetfeld eine Amplitude *(B_{osc})* aufweist;
- Aussetzen der Stickstoffleerstellenzentren gegenüber dem ersten Magnetfeld;
- Anlegen (S402) eines Mikrowellensignals an den Diamanten; Beleuchten des Diamanten unter Verwendung von grünem Licht, um zu bewirken, dass die Stickstoffleerstellenzentren eine Fluoreszenz emittieren;
wobei die Amplitude des oszillierenden Magnetfelds ausreichend hoch ist, um Resonanzen in der Fluoreszenz bei der Mikrowellensignalfrequenz oder bei Harmonischen der Mikrowellensignalfrequenz zu bewirken;
- Bestimmen (S403) einer zeitlichen Lage der Resonanzen;
- Erhalten (S404) einer Messung des ersten Magnetfelds als eine Funktion der zeitlichen Lage der Resonanzen, wobei die zeitliche Lage der Resonanzen durch Zeitstempeln der Abfälle in dem Fluoreszenzsignal unter Verwendung eines Zählers erhalten wird.

2. Verfahren nach Anspruch 1, wobei das Mikrowellensignal ein Signal mit fester Frequenz (f_{RF}) ist.

3. Verfahren nach Anspruch 2, wobei sich die feste Frequenz (S701) außerhalb eines Frequenzbereichs befindet, umfassend eine Stickstoffleerstellen-Nullfeldaufspaltungsfrequenz (D_{g}), wobei der Bereich ein Bereich ist, in dem eine mechanische Dehnung (E) des Diamanten die Messung beeinflusst.

4. Verfahren nach Anspruch 3, umfassend ein Bereitstellen des Mikrowellensignals bei einer Vielzahl von festen Frequenzen außerhalb des Bereichs und das Bestimmen der zeitlichen Lage von Resonanzen bei jeder der Vielzahl von festen Frequenzen, um die Messung des ersten Magnetfelds zu erhalten.

5. Verfahren nach einem der Ansprüche 1 bis 4, ferner umfassend
- Einstellen des oszillierenden Magnetfelds in einem spezifischen Winkel in Bezug auf jede Ausrichtung der Stickstoffleerstellenzentren derart, dass das projizierte Feld entlang jeder Ausrichtung unterschiedlich ist, sodass die zeitliche Lage der Resonanzen für jede Ausrichtung unterschiedlich ist; und
- Erhalten einer separaten Messung des zu messenden Magnetfelds für jede Ausrichtung basierend auf der jeweiligen zeitlichen Lage der Resonanzen.

6. Verfahren nach einem der Ansprüche 1 bis 5, ferner umfassend ein Mitteln der jeweiligen zeitlichen Lagen eines Teilsatzes von Resonanzen während einer Phase des oszillierenden Anregungsmagnetfelds und das Erhalten der Messung des Magnetfelds basierend auf den gemittelten zeitlichen Lagen.

7. Vorrichtung (900) zum Messen eines ersten Magnetfelds (Bₘ), umfassend:
- einen mit NV-Zentren dotierten Diamanten (901);
- eine grüne Lichtquelle (902), die zum optischen Pumpen der NV-Zentren eingerichtet ist;
- einen Fotodetektor (905) zum Detektieren einer Fluoreszenz der NV-Zentren;
- eine Mikrowellenquelle (904), die ein Mikrowellenfrequenzsignal zum Anlegen an die NV-Zentren erzeugt;
- eine Quelle (903) eines zeitlich oszillierenden Magnetfelds;
- einen Prozessor (906) zum Verarbeiten des Signals von dem Fotodetektor und Bereitstellen eines oder mehrerer Größenwerte des ersten Magnetfelds durch Messen des ersten Magnetfelds als eine Funktion der zeitlichen Lage der Resonanzen, wobei die zeitliche Lage der Resonanzen durch Zeitstempeln der Abfälle in dem Fluoreszenzsignal unter Verwendung eines Zählers erhalten wird;
- einen Speicher (907) mit Softwarecode, der, wenn er durch den Prozessor ausgeführt wird, bewirkt, dass die Vorrichtung ein Verfahren nach einem der Ansprüche 1 bis 6 durchführt.

## Revendications

1. Procédé permettant de mesurer un premier champ magnétique (Bₘ), comprenant :
- l'application (S401) d'un champ magnétique oscillant dans le temps à un diamant (901) comprenant des centres azote-lacune, le champ magnétique ayant une amplitude *(B_{osc}) ;*
- l'exposition des centres azote-lacune au premier champ magnétique ;
- l'application (S402) d'un signal hyperfréquence au diamant ; l'éclairage du diamant à l'aide d'une lumière verte pour amener les centres azote-lacune à émettre une fluorescence ;
dans lequel l'amplitude du champ magnétique oscillant est suffisamment élevée pour provoquer des résonances dans la fluorescence à la fréquence du signal hyperfréquence ou à des harmoniques de la fréquence du signal hyperfréquence ;
- la détermination (S403) d'un instant des résonances ;
- l'obtention (S404) d'une mesure du premier champ magnétique en fonction de l'instant des résonances, l'instant des résonances étant obtenu par horodatage des baisses du signal de fluorescence à l'aide d'un compteur.

2. Procédé selon la revendication 1, dans lequel le signal hyperfréquence est un signal à fréquence fixe (f_{RF}).

3. Procédé selon la revendication 2, dans lequel la fréquence fixe est située (S701) en dehors d'une plage de fréquences comprenant une fréquence de séparation en champ nul azote-lacune (D_{g}), ladite plage étant une plage dans laquelle une déformation mécanique (E) du diamant affecte la mesure.

4. Procédé selon la revendication 3, comprenant la fourniture du signal hyperfréquence à une pluralité de fréquences fixes en dehors de la plage et la détermination de l'instant des résonances à chacune de ladite pluralité de fréquences fixes pour obtenir la mesure du premier champ magnétique.

5. Procédé selon l'une des revendications 1 à 4, comprenant en outre
- le règlement du champ magnétique oscillant à un angle spécifique par rapport à chaque orientation des centres azote-lacune de telle sorte que le champ projeté selon chaque orientation est différent afin que l'instant des résonances pour chaque orientation soit différent ; et
- l'obtention d'une mesure séparée du champ magnétique à mesurer pour chaque orientation sur la base de l'instant respectif des résonances.

6. Procédé selon l'une des revendications 1 à 5, comprenant en outre le calcul de la moyenne des instants respectifs d'un sous-ensemble de résonances pendant une phase du champ magnétique d'excitation oscillant et l'obtention de ladite mesure du champ magnétique sur la base des instants moyennés.

7. Dispositif (900) permettant de mesurer un premier champ magnétique (Bₘ), comprenant :
- un diamant (901) dopé avec des centres NV ;
- une source de lumière verte (902) agencée pour pomper optiquement les centres NV ;
- un photodétecteur (905) pour détecter une fluorescence des centres NV ;
- une source d'hyperfréquence (904) générant un signal d'hyperfréquence pour application aux centres NV ;
- une source (903) de champ magnétique oscillant dans le temps ;
- un processeur (906) pour traiter le signal provenant du photodétecteur et fournir une ou plusieurs valeurs d'amplitude du premier champ magnétique, en mesurant le premier champ magnétique en fonction de l'instant des résonances, l'instant des résonances étant obtenu par horodatage des baisses du signal de fluorescence à l'aide d'un compteur ;
- une mémoire (907) avec un code logiciel qui, lorsqu'il est exécuté par le processeur, amène le dispositif à réaliser un procédé selon l'une des revendications 1 à 6.
